# EUROPEAN PATENT SPECIFICATION

(11) **EP 4 383 346 B1**
(45) Date of publication and mention of the grant of the patent: **27.05.2026**
(21) Application number: 22874299.5
(22) Date of filing: 20.06.2022
(51) Int. Cl.: H10D 30/01, H10D 62/10, H10D 62/17, H10D 64/27, H10D 30/47, H10D 62/85

(54) **SEMICONDUCTOR DEVICE AND MANUFACTURING METHOD THEREFOR**
HALBLEITERBAUELEMENT UND HERSTELLUNGSVERFAHREN DAFÜR
DISPOSITIF À SEMI-CONDUCTEURS ET SON PROCÉDÉ DE FABRICATION

(30) Priority: 30.09.2021 CN 202111163668
(43) Date of publication of application: 12.06.2024
(73) Proprietor: Huawei Digital Power Technologies Co., Ltd., Shenzhen, Guangdong 518043 (CN)
(72) Inventor: SUN, Hui, Shenzhen, Guangdong 518043 (CN); GAO, Biao, Shenzhen, Guangdong 518043 (CN); CHEN, Zhibin, Shenzhen, Guangdong 518043 (CN); HOU, Yong, Shenzhen, Guangdong 518043 (CN)
(74) Representative: Epping - Hermann - Fischer
(86) International application number: PCT/CN2022/099667
(87) International publication number: WO 2023/050902

(56) References cited:
- WO-A1-2020/174956
- CN-A- 107 768 439
- CN-A- 111 370 300
- CN-A- 111 370 471
- CN-A- 112 750 700
- US-A1- 2017 133 500
- US-A1- 2020 176 595
- US-A1- 2020 212 173
- US-A1- 2020 212 197

## Description

### TECHNICAL FIELD

This application relates to the field of semiconductor manufacturing technologies, and in particular, to a semiconductor device and a manufacturing method thereof.

### BACKGROUND

Wide-bandgap semiconductor gallium nitride (gallium nitride, GaN) has a high breakdown electric field, high electron mobility, and a high saturated electron drift velocity, and has a wide application prospect in the field of power electronics and radio frequency microwave.

Currently, a gallium nitride device mainly includes a device based on an aluminum gallium nitride (AlGaN)/GaN heterostructure, for example, a high electron mobility transistor (high electron mobility transistor, HEMT) manufactured by using an AlGaN/GaN heterostructure as a core. The HEMT has excellent performance, is very suitable for manufacturing a power semiconductor device, and is currently widely concerned in the industry. Piezoelectric polarization and spontaneous polarization that are generated by the AlGaN/GaN cause a high concentration of two-dimensional electron gas (two-dimensional electron gas, 2-DEG) to be formed at an interface of the heterostructure, and mobility and a saturation velocity of the 2-DEG are far higher than those of silicon.

In the gallium nitride device, a doped layer may be formed on the surface of the AlGaN/GaN heterostructure of a gate region, a gate structure is formed on the doped layer, and stacked doped layer and gate structure are formed. The doped layer may be a p-type GaN (p-GaN) layer or a p-type AlGaN (p-AlGaN) layer. When the gallium nitride device of such a structure works, a side wall of the gate structure and a side wall of the doped layer form a leakage channel, and consequently an electrical parameter such as gate leakage (gate leakage, Igleak) is affected.

US 2020/212173 A1 discloses a gate structure for gallium nitride (GaN) high electron mobility transistor (HEMT) including a heterogeneous structure, a doped GaN layer, an insulating layer, an undoped GaN layer, and a gate metal layer. The heterogeneous structure includes a channel layer and a barrier layer on the channel layer. The doped GaN layer is disposed on the barrier layer, the insulating layer is disposed on both sides of the top portion of the doped GaN layer, and the undoped GaN layer is disposed between the doped GaN layer and the insulating layer. The gate metal layer is disposed on the doped GaN layer and covers the insulating layer and the undoped GaN layer. The undoped GaN layer can protect the underlying doped GaN layer, and the insulating layer has the effect of preventing gate leakage.

WO 2020/174956 A1 discloses a nitride semiconductor device comprising: a first nitride semiconductor layer that constitutes an electron transport layer; a second nitride semiconductor layer that is formed upon the first nitride semiconductor layer and constitutes an electron supply layer; a nitride semiconductor gate layer that is provided upon the second nitride semiconductor layer, has a ridge on at least a part thereof, and contains acceptor impurities; a gate electrode that is provided upon at least the ridge of the nitride semiconductor gate layer; a source electrode that is provided upon the second nitride semiconductor layer and has a main source electrode part that is parallel to the ridge; and drain electrode that is provided upon the second nitride semiconductor layer and has a main drain electrode part that is parallel to the ridge.

US 2020/212197 A1 discloses a method of manufacturing a gate structure for gallium nitride (GaN) high electron mobility transistor (HEMT) includes orderly forming a channel layer, a barrier layer, a doped GaN layer, an undoped GaN layer, and an insulating layer on a substrate, and then removing a portion of the insulating layer to form a trench. A gate metal layer is formed on the substrate to cover the insulating layer and the trench, and then a mask layer aligned with the trench is formed on the gate metal layer, wherein the mask layer partially overlaps the insulating layer. By using the mask layer as an etching mask, the exposed gate metal layer and the underlying insulating layer, the undoped GaN layer and the doped GaN layer are removed, and then the mask layer is removed.

US 2017/133500 A1 discloses a nitride semiconductor device including a substrate, a p-type GaN layer formed on a main surface of the substrate and made of AlxInyGa1-x-yN containing p-type impurities, where 0≦X < 1, 0≦Y < 1, and a Ti film formed on the p-type GaN layer. The Ti film is in a coherent or metamorphic state with respect to the p-type GaN layer.

### SUMMARY

In view of this, embodiments of this application provide a semiconductor device, so as to improve device performance.

According to the invention a semiconductor device is provided. The semiconductor device includes a channel layer and a barrier layer that are sequentially stacked, a doped layer, and a gate structure. The channel layer and the barrier layer each are made of a group III nitride material. The barrier layer has a gate region. The doped layer is located on a side that is of the barrier layer and that is away from the channel layer. The doped layer is located in the gate region. A material of the doped layer is a group III-V compound including a p-type doped element. The gate structure is located on a side that is of the doped layer and that is away from the channel layer. A side wall that is of the gate structure and that is close to the doped layer is retracted relative to a side wall of the doped layer, and the side wall that is of the gate structure and that is close to the doped layer is retracted relative to a side wall that is of the gate structure and that is away from the doped layer, so that the side wall of the gate structure and the side wall of the doped layer are not in a same plane. A retraction structure of the side wall that is of the gate structure and that is close to the doped layer blocks contact between the side wall that is of the gate structure and that is away from the doped layer and the side wall of the doped layer, which is equivalent to blocking a leakage channel between the gate structure and the doped layer, thereby reducing a leakage current of the device and improving device performance.

In some possible implementations, a material of the channel layer is gallium nitride, a material of the barrier layer is aluminum gallium nitride, and a material of the doped layer is gallium nitride or aluminum gallium nitride that includes the p-type doped element.

In this embodiment of this application, the material of the channel layer may be gallium nitride, the material of the barrier layer is aluminum gallium nitride, and two-dimensional electron gas may be formed at an interface between the channel layer and the barrier layer. The material of the doped layer is gallium nitride or aluminum gallium nitride that includes the p-type doped element, so that the two-dimensional electron gas in the gate region can be better exhausted, and the doped layer is in good contact with the barrier layer, which helps improve device performance.

According to the invention, a dielectric structure is disposed on a periphery of the side wall that is of the gate structure and that is close to the doped layer, so that the side wall that is of the gate structure and that is away from the doped layer, a side wall of the dielectric structure, and a part of the side wall of the doped layer that is close to the gate structure are flush. The side wall that is of the gate structure and that is away from the doped layer, and the side wall of the dielectric structure are not flush with another part of the side wall that is of the doped layer and that is away from the gate structure.

According to the invention, the side wall that is of the gate structure and that is close to the doped layer forms a sunken structure, and the dielectric structure is disposed on the periphery of the side wall, so that the side wall that is of the gate structure and that is away from the doped layer, the side wall of the dielectric structure, and the part of the side wall of the doped layer are flush. That is, the sunken structure is filled by using the dielectric structure. Therefore, when an overall structure is stable, the dielectric structure can better block the leakage channel between the side wall of the gate structure and the side wall of the doped layer, thereby improving device performance. In some possible implementations, the other part of the side wall of the doped layer and the side wall of the dielectric structure are not parallel.

Certainly, there may be spacing or no spacing between the dielectric structure and the sunken structure. The sunken structure is filled, so that when an overall structure is stable, the dielectric structure can better block the leakage channel between the side wall of the gate structure and the side wall of the doped layer, thereby improving device performance.

In some possible implementations, a material of the dielectric structure includes at least one of the following materials: SiO₂, SiON, SiNx, AlOx, AlNx, GaOx, and TiOx.

In embodiments of this application, the material of the dielectric structure may be a material with good insulation, so as to better block the leakage channel between the side wall of the gate structure and the side wall of the doped layer, thereby improving device performance.

In some possible implementations, in a plane parallel to a surface of the channel layer, the dielectric structure surrounds the gate structure, and widths of a plurality of parts that are of the dielectric structure and that are located on different sides of the gate structure are not the same.

In embodiments of this application, the dielectric structure may surround the gate structure from all side surfaces, to fill, from all side walls, the sunken structure of the side wall that is of the gate structure and that is close to the doped layer. The widths of the plurality of parts that are of the dielectric structure and that are located on different sides are not the same, so that the device can adapt to more application scenarios.

In some possible implementations, a size of the dielectric structure in a direction perpendicular to the surface of the channel layer is less than 5 microns.

In embodiments of this application, the thickness of the dielectric structure is less than 5 microns, so that the thickness of the dielectric structure is relatively small. In this way, when the dielectric structure is etched, regardless of dry etching or wet etching, a damage caused to the barrier layer is relatively small, thereby improving device performance. In some possible implementations, a material of the gate structure includes at least one of the following materials: Ti, TiN, W, Ni, NiV, Ta, TaN, Pd, Pt, WSi₂, and Au.

In embodiments of this application, the material of the gate structure may be a material with relatively good conductivity, to improve device performance.

In some possible implementations, the semiconductor device further includes:
a source and a drain, where the source and the drain are located on the side that is of the barrier layer and that is away from the channel layer, and the source and the drain are located on two sides of the gate region.

In embodiments of this application, the source and the drain on the two sides of the gate region may be further included, to form a complete device and implement relatively high device performance.

In some possible implementations, the semiconductor device further includes:
a substrate, where the substrate is located on a side that is of the channel layer and that is away from the barrier layer.

In embodiments of this application, the substrate may be disposed on the side that is of the channel layer and that is away from the barrier layer, to support a film layer disposed on the substrate, thereby improving reliability of the device.

In some possible implementations, the semiconductor device further includes:
a buffer layer located between the substrate and the channel layer.

In embodiments of this application, the buffer layer may be further disposed between the substrate and the channel layer, so as to improve quality of the channel layer, thereby improving device performance.

According to a second aspect of an example useful for understanding the invention but not forming part of the invention, a semiconductor device manufacturing method is provided, and includes:
sequentially forming a barrier layer, a doped material layer, and a dielectric material layer on a channel layer, where the channel layer is made of a group III nitride material, the barrier layer is made of a group III nitride material, the barrier layer has a gate region, and a material of the doped material layer is a group III-V compound including a receptor-type doped element;
etching the dielectric material layer located in the gate region and located on the doped material layer, to form a gate region groove that runs through the dielectric material layer;
depositing a gate material, so that the gate material fills the gate region groove and covers the dielectric material layer; and
etching the gate material, the dielectric material layer, and the doped material layer to form a doped layer located in the gate region and a gate structure that is on the doped layer, where a dielectric structure is disposed on a periphery of a side wall that is of the gate structure and that is close to the doped layer, so that a side wall that is of the gate structure and that is away from the doped layer and a side wall of the dielectric structure are flush.

In some possible implementations, a material of the channel layer is gallium nitride, a material of the barrier layer is aluminum gallium nitride, and a material of the doped layer is gallium nitride or aluminum gallium nitride that includes the receptor-type doped element.

In some possible implementations, the side wall of the dielectric structure and at least a part of a side wall of the doped layer are flush; and/or at least a part of the side wall of the doped layer and the side wall of the dielectric structure are not parallel.

In some possible implementations, before the etching the gate material, the dielectric material layer, and the doped material layer, the method further includes:
forming a hard mask layer on the gate material; and etching the hard mask layer while etching the gate material, the dielectric material layer, and the doped material layer; and
after the etching the gate material, the dielectric material layer, and the doped material layer, the method further includes:
   etching the gate structure through wet etching and by using the hard mask layer as a mask, so that at least one side wall of the gate structure is flush.

In some possible implementations, after the etching the gate structure through wet etching, the method further includes:
removing the hard mask layer, and/or removing the dielectric structure.

In some possible implementations, a material of the dielectric structure includes at least one of the following materials: SiO₂, SiON, SiNx, AlOx, AlNx, GaOx, and TiOx.

In some possible implementations, in a plane parallel to a surface of the channel layer, the dielectric structure surrounds the gate structure, and widths of a plurality of parts that are of the dielectric structure and that are located on different sides of the gate structure are not completely the same.

In some possible implementations, a size of the dielectric structure in a direction perpendicular to the surface of the channel layer is less than 5 µm.

In some possible implementations, the etching the dielectric material layer located in the gate region and located on the doped material layer is implemented through dry etching or wet etching.

In some possible implementations, a material of the gate structure includes at least one of the following materials: Ti, TiN, W, Ni, NiV, Ta, TaN, Pd, Pt, WSi₂, and Au.

In some possible implementations, the method further includes:
forming a source and a drain on the barrier layer, where the source and the drain are located on two sides of the gate region.

In some possible implementations, a substrate is disposed on a side that is of the channel layer and that is away from the barrier layer.

In some possible implementations, a buffer layer is disposed between the channel layer and the substrate. According to a third aspect of embodiments of this application, an electronic device is provided, and includes a circuit board and the semiconductor device that is connected to the circuit board and that is provided in the first aspect of this application.

According to the foregoing technical solutions, it can be learned that embodiments of this application have the following advantages.

Embodiments of this application provide the semiconductor device. The semiconductor device may include the channel layer and the barrier layer that are sequentially stacked, the doped layer, and the gate structure. The channel layer and the barrier layer each are made of the group III nitride material. The barrier layer has the gate region. The doped layer is located on the side that is of the barrier layer and that is away from the channel layer. The doped layer is located in the gate region. The material of the doped layer is the group III-V compound including the receptor-type doped element. The gate structure is located on the side that is of the doped layer and that is away from the channel layer. The side wall that is of the gate structure and that is close to the doped layer is retracted relative to the side wall of the doped layer, and the side wall that is of the gate structure and that is close to the doped layer is retracted relative to the side wall that is of the gate structure and that is away from the doped layer, so that the side wall of the gate structure and the side wall of the doped layer are not in the same plane. The retraction structure of the side wall that is of the gate structure and that is close to the doped layer blocks contact between the side wall that is of the gate structure and that is away from the doped layer and the side wall of the doped layer, which is equivalent to blocking the leakage channel between the gate structure and the doped layer, thereby reducing the leakage current of the device and improving the device performance. The invention is defined by the appended set of claims.

### BRIEF DESCRIPTION OF DRAWINGS

To clearly understand specific implementations of this application, the following briefly describes accompanying drawings used for describing specific implementations of this application. It is clear that, the accompanying drawings show merely some embodiments of this application.
FIG. 1 is a schematic diagram of a structure of a gallium nitride device;
FIG. 2-4, FIG. 6 and FIG. 8-9 are schematic diagrams of structures of semiconductor devices according to embodiments not falling under the scope of the claims; FIG. 5 and FIG. 7 are schematic diagrams of structures of semiconductor devices according to the invention;
FIG. 10 is a flowchart of a semiconductor device manufacturing method according to an example not forming part of the present invention; and
FIG. 11 to FIG. 22 are schematic diagrams of structures of devices in a semiconductor device manufacturing process according to examples not forming part of the present invention.

### DESCRIPTION OF EMBODIMENTS

Embodiments of this application provide a semiconductor device, to improve optical-to-electrical conversion efficiency of the device.

In the specification, claims, and accompanying drawings of this application, the terms "first", "second", "third", "fourth", and the like (if existent) are intended to distinguish between similar objects but do not necessarily indicate a specific order or sequence. It should be understood that the data termed in such a way is interchangeable in proper circumstances so that embodiments of described herein can be implemented in orders other than the order illustrated or described herein. Moreover, the terms "include", "contain" and any other variants mean to cover the non-exclusive inclusion, for example, a process, method, system, product, or device that includes a list of steps or units is not necessarily limited to those steps or units, but may include other steps or units not expressly listed or inherent to such a process, method, product, or device.

This application is described in detail with reference to the schematic diagram. For ease of description, when embodiments of this application are described in detail, a sectional view of a device structure is not partially enlarged in a general proportion, and the schematic diagram is merely an example, and should not limit the protection scope of this application. In addition, sizes of the length, width, and depth in a three-dimensional space should be included in actual production.

In a gallium nitride device, a doped layer may be formed on an AlGaN/GaN heterostructure surface of a gate region, a gate structure is formed on the doped layer, and stacked doped layer and gate structure are formed. The doped layer may be a p-type GaN (p-GaN) layer or a p-type AlGaN (p-AlGaN) layer. Specifically, the doped layer may exhaust a two-dimensional electronic gas channel in the gate region, and a non-gate region outside the gate region does not form the doped layer, so that the gate region has no channel, and the non-gate region has a channel. In this way, a gate is used to control the channel.

However, when the gallium nitride device of this structure works, a leakage channel is formed between a side wall of the gate and a side wall of the doped layer. Consequently, an electrical parameter such as gate leakage (gate leakage, Igleak) is affected. This is because in an etching process of the gate structure and the doped layer, an etching damage is inevitably formed on the side wall of the gate structure and the side wall of the doped layer, and a leakage current is formed by capturing a charge at a damaged position.

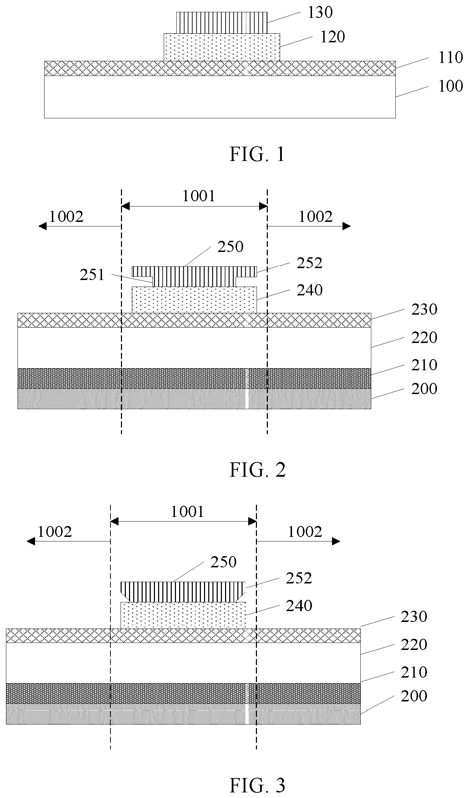

FIG. 1 is a schematic diagram of a structure of a gallium nitride device. The gallium nitride device may include a GaN layer 100 and an AlGaN layer 110 that are disposed in a stacked manner. The AlGaN layer 110 may include a doped layer 120 located in a gate region of an AlGaN/GaN heterostructure surface, and a gate structure 130 located on the doped layer 120, and a transverse size of the gate structure 130 is less than a transverse size of the doped layer 120, so that a stepped structure is formed between the gate structure 130 and the doped layer 120. In this way, a side wall of the gate structure and a side wall of the doped layer are not in a same plane, and the two are discontinuous, thereby preventing the side wall of the gate structure and the side wall of the doped layer from forming a leakage channel, and improving performance of an HEMT device formed based on an AlGaN/GaN heterostructure.

Currently, the gate structure and the doped layer may be obtained through hard mask etching, so that the side wall of the gate structure and the side wall of the doped layer are flush, and then the gate structure is laterally etched by using wet etching, so that the side wall of the gate structure is retracted relative to the side wall of the doped layer, and a connection between the side wall of the gate structure and the side wall of the doped layer is blocked, thereby avoiding the side wall of the gate structure and the side wall of the doped layer from forming the leakage channel. However, when the gate structure is laterally etched by using wet etching to obtain the stepped structure between the gate structure and the doped layer, the side wall of the gate structure is prone to form a thin metamorphic layer during an etching process, which affects etching of the side wall of the gate structure. Consequently, when the stepped structure is formed, the side wall of the gate structure is not flat and is in a sawtooth shape, affecting a subsequent manufacturing process, and the obtained stepped structure is in a poor shape.

Based on the foregoing technical problems, embodiments of this application provide a semiconductor device and a manufacturing method thereof. The semiconductor device may include a channel layer and a barrier layer that are sequentially stacked, a doped layer, and a gate structure. The barrier layer has a gate region. The channel layer and the barrier layer each are made of a group III nitride material. The doped layer is located on a side that is of the barrier layer and that is away from the channel layer. The doped layer is located in the gate region. A material of the doped layer is a group III-V compound including a receptor-type doped element. The gate structure is located on a side that is of the doped layer and that is away from the channel layer. A side wall that is of the gate structure and that is close to the doped layer is retracted relative to a side wall of the doped layer, and the side wall that is of the gate structure and that is close to the doped layer is retracted relative to a side wall that is of the gate structure and that is away from the doped layer, so that the side wall of the gate structure and the side wall of the doped layer are not in a same plane. A retraction structure of the side wall that is of the gate structure and that is close to the doped layer blocks contact between the side wall that is of the gate structure and that is away from the doped layer and the side wall of the doped layer, which is equivalent to blocking a leakage channel between the gate structure and the doped layer, thereby reducing a leakage current of the device and improving device performance.

To make the objectives, features, and advantages of this application clearer and more understandable, the following describes specific implementations of this application in detail with reference to the accompanying drawings.

FIG. 2 is a schematic diagram of a structure of a semiconductor device according to an embodiment not falling under the scope of the invention.

The semiconductor device may include a channel layer 220, a barrier layer 230, a doped layer 240, and a gate structure 250 that are sequentially disposed in a stacked manner. The channel layer 220 is made of a group III nitride material, and the barrier layer 230 is made of a group III nitride material. For example, a material of the channel layer 220 may be gallium nitride, and a material of the barrier layer 230 may be one of aluminum gallium nitride, aluminum nitride, and the like. In this case, the channel layer 220 and the barrier layer 230 form a heterostructure, for example, an AlGaN/GaN heterostructure. In this way, two-dimensional electron gas is generated, and a semiconductor device formed on this basis may work by using the two-dimensional electron gas generated by the heterostructure. The semiconductor device may be, for example, a high-electron-mobility transistor (high-electron-mobility transistor, HEMT) device based on a heterostructure.

In a possible implementation, the thickness of the channel layer 220 may be relatively large. In this case, the channel layer 220 may be used as a substrate, and the substrate supports a film layer that is on the substrate. For example, the channel layer 220 whose material is gallium nitride may be used as the substrate, and is also used as a composition component of the AlGaN/GaN heterostructure.

In another possible implementation, the thickness of the channel layer 220 may be relatively small. In this case, the channel layer 220 may be formed on the substrate 200, the substrate 200 is disposed on a side that is of the channel layer 220 and that is away from the barrier layer 230, the substrate 200 supports a film layer that is on the substrate, the channel layer 220 is used as a composition component of a heterostructure, and a material of the substrate 200 may be a group III-V compound semiconductor material, and may be one or more of aluminum nitride (AlN), silicon (Si), silicon carbide (SiC), or sapphire. Optionally, a buffer layer 210 may be further disposed between the substrate 200 and the channel layer 220. A material of the buffer layer 210 may be aluminum nitride, or may be gallium nitride growing at a low temperature. When the buffer layer 210 is made of gallium nitride growing at a low temperature, the channel layer 220 may be a layer made of gallium nitride growing at a high temperature. In this way, the low-temperature gallium nitride layer is used as the buffer layer 210 between the high-temperature gallium nitride layer and the substrate 200, thereby improving epitaxial quality of the high-temperature gallium nitride layer.

The barrier layer 230 may have a gate region 1001 and a non-gate region 1002 that is on a periphery of the gate region 1001. The gate region 1001 is a region on a surface of the barrier layer 230, and includes space defined by the surface of the barrier layer 230 and countless straight lines perpendicular to the surface of the barrier layer 230. The gate region 1001 is used to form the gate structure 250. A size of the gate region 1001 may be greater than or equal to that of a region in which the gate structure 250 is located. In FIG. 2, a dashed-line box in the middle represents the gate region 1001, and two sides of the gate region 1001 represent the non-gate region 1002. A same representation manner is used in subsequent schematic diagrams of structures. Because FIG. 2 is a sectional view, the non-gate region 1002 may be actually located on the two sides of the gate region 1001, and may form an annular region, such as a ring region or a polygon region, surrounding the gate region 1001.

In this embodiment of this application, the doped layer 240 may be formed on the surface of the barrier layer 230 in the gate region 1001. In other words, the doped layer 240 is disposed on a side that is of the barrier layer 230 and that is away from the channel layer 220, and the doped layer 240 is located in the gate region 1001. A material of the doped layer 240 may be a group III-V compound including a receptor-type doped element. For example, the material of the doped layer 240 may be gallium nitride or aluminum gallium nitride including the receptor-type (P-type) doped element. Correspondingly, the doped layer may be represented as p-type GaN (p-GaN) or p-type AlGaN (p-AlGaN). The doped layer 240 may be configured to exhaust a two-dimensional electronic gas channel of the gate region 1001, and the non-gate region 1002 outside the gate region 1001 does not form the doped layer, so that the gate region 1001 has no channel, and the non-gate region 1002 has a channel. In this way, the gate structure 250 is used to control the channel.

In this embodiment of this application, the gate structure 250 is formed on the doped layer 240, and the gate structure 250 is disposed on a side that is of the doped layer 240 and that is away from the channel layer 220. A material of the gate structure 250 may have good conductivity, and the material of the gate structure 250 may be at least one of Ti, TiN, W, Ni, NiV, Ta, TaN, Pd, Pt, WSi₂, and Au.

In this embodiment of this application, a side wall that is of the gate structure 250 and that is close to the doped layer 240 is retracted relative to a side wall of the doped layer 240, and the side wall that is of the gate structure 250 and that is close to the doped layer 240 is retracted relative to a side wall that is of the gate structure 250 and that is away from the doped layer 240, so that in a direction along the surface of the barrier layer 230, a size of a part that is of the gate structure 250 and that is close to the doped layer 240 is less than a size of a part that is of the gate structure 250 and that is away from the doped layer 240, and less than a size of the doped layer 240. The part that is of the gate structure 250 and that is close to the doped layer 240 forms a sunken structure as a whole, so that the side wall of the gate structure 250 and the side wall of the doped layer 240 are not in a same plane, thereby blocking continuity of the side wall of the gate structure 250 and the side wall of the doped layer 240, and preventing a leakage channel from being formed between the side wall of the gate structure 250 and the side wall of the doped layer 240.

Refer to FIG. 2. The gate structure 250 has a side wall 251 close to the doped layer 240 as one part of side walls of the gate structure 250, and a side wall 252 away from the doped layer 240 as the other part of the side walls of the gate structure 250. The two parts of side walls jointly form the side walls of the gate structure 250. The side wall 251 close to the doped layer 240 not only is retracted relative to the side wall of the doped layer 240, but also is retracted relative to the side wall away from the doped layer 240, to form the retraction structure, so that the side wall of the gate structure 250 and the side wall of the doped layer 250 are not in a same plane. Because the retraction structure of the side wall 251 that is of the gate structure 250 and that is close to the doped layer 240 blocks continuity of the side wall of the gate structure 250 and the side wall of the doped layer 240, which is equivalent to blocking a leakage channel between the gate structure 250 and the doped layer 240, a leakage current of the device is reduced, and device performance is improved.

FIG. 2 is a schematic sectional view. Actually, the gate structure 250 forms a polygonal structure in a plane parallel to the barrier layer 230. In this case, the retraction structure is formed on at least one side wall of the gate structure 250, for example, may be formed on all side walls of the gate structure 250, and the retraction structure forms a closed ring. In some possible implementations, the side wall 251 that is of the gate structure 250 and that is close to the doped layer 240 is perpendicular to a surface that is of the doped layer 240 and that faces the gate structure 250. In other words, an included angle between the side wall and a part of a surface that is of the doped layer 240, that faces the gate structure 250, and that is not covered by the gate structure 250 is equal to 90°, as shown in FIG. 2. To be specific, the side wall 251 that is of the gate structure 250 and that is close to the doped layer 240 and the side wall of the doped layer 240 are discontinuous, and the side wall 251 and the side wall 252 that is of the gate structure 250 and that is away from the doped layer 240 are also discontinuous. Therefore, contact between the side wall 252 that is of the gate structure 250 and that is away from the doped layer 240 and the side wall of the doped layer 240 can be blocked, so that the leakage channel between the gate structure 250 and the doped layer 240 can be blocked. Therefore, the leakage current of the device is reduced, and the device performance is improved.

In some other possible implementations, the side wall 251 that is of the gate structure 250 and that is close to the doped layer 240 may not be perpendicular to a surface that is of the doped layer 240 and that faces the gate structure 250. In other words, an included angle between the side wall and a part of a surface that is of the doped layer 240, that faces the gate structure 250, and that is not covered by the gate structure 250 is not equal to 90°, for example, is less than 90°. FIG. 3 is a schematic diagram of a structure of another semiconductor device according to an embodiment not falling under the scope of the invention.

To be specific, the side wall 251 that is of the gate structure 250 and that is close to the doped layer 240 and the side wall of the doped layer 240 are discontinuous, the side wall 251 that is of the gate structure 250 and that is close to the doped layer 240 intersects with the part of the surface that is of the doped layer 240, that faces the gate structure 250, and that is not covered by the gate structure 250, and an included angle in intersection is not equal to 90°, for example, is less than 90°. In addition, the side wall 251 that is of the gate structure 250 and that is close to the doped layer 240 intersects with the side wall 252 that is of the gate structure 250 and that is away from the doped layer 240, and an included angle in intersection is not equal to 90°, for example, is greater than 90°. Therefore, when the side wall 251 that is of the gate structure 250 and that is close to the doped layer 240 is not perpendicular to the surface that is of the doped layer 240 and that faces the gate structure 250, contact between the side wall 252 that is of the gate structure 250 and that is away from the doped layer 240 and the side wall of the doped layer 240 can still be blocked, so that the leakage channel between the gate structure 250 and the doped layer 240 can be blocked. Therefore, the leakage current of the device is reduced, and the device performance is improved.

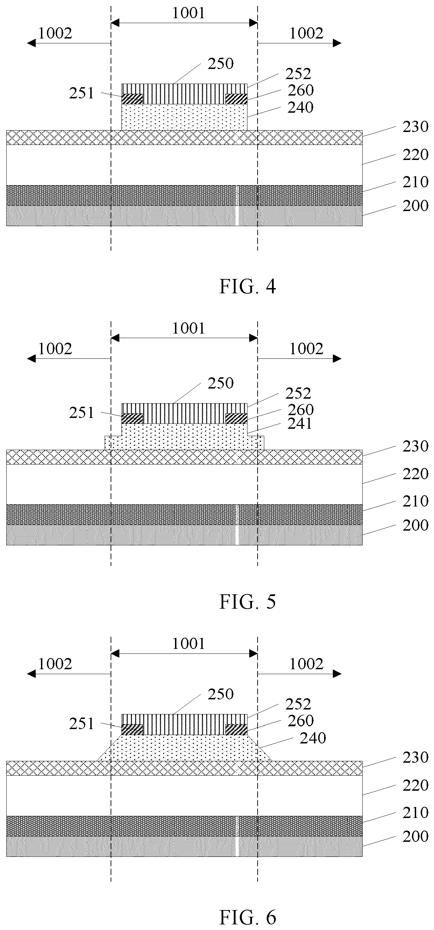

In this embodiment of this application, a dielectric structure 260 may be disposed at a periphery of the side wall 251 that is of the gate structure 250 and that is close to the doped layer 240. FIG. 4 is a schematic diagram of a structure of still another semiconductor device not falling under the scope of the invention. To be specific, there is a dielectric material in the retraction structure of the side wall 251 that is of the gate structure 250 and that is close to the doped layer 240, to form the dielectric structure 260, and the retraction structure is filled with the dielectric material, so that a side wall of the formed dielectric structure 260 and the side wall 252 that is of the gate structure 250 and that is away from the doped layer 240 are flush. In this way, the side wall of the dielectric structure 260 is located between the side wall 252 that is of the gate structure 250 and that is away from the doped layer 240 and the side wall of the doped layer 240, so that the dielectric material is used to block the leakage channel between the gate structure 250 and the doped layer 240. A material of the dielectric structure 260 may be a material with relatively good insulation, and the material of the dielectric structure 260 may be at least one of SiO₂, SiON, SiNx, AlOx, AlNx, GaOx, and TiOx.

In this embodiment of this application, the side wall of the dielectric structure 260 and the side wall 252 that is of the gate structure 250 and that is away from the doped layer 240 are flush. The side wall of the dielectric structure 260 and at least a part of the side wall of the doped layer 240 may be flush. Specifically, the side wall of the dielectric structure 260 and the entire side wall of the doped layer 240 may be flush, or the side wall of the dielectric structure 260 and a part of the side wall of the doped layer 240 may be flush.

In some possible implementations, not falling under the scope of the invention, the side wall 252 that is of the gate structure 250 and that is away from the doped layer 240, the side wall of the dielectric structure 260, and the side wall of the doped layer 240 are flush, as shown in FIG. 4. In this case, the side wall 251 that is of the gate structure 250 and that is close to the doped layer 240 and the side wall of the doped layer 240 are not in a same plane, and the side wall of the dielectric structure 260 is located between the side wall 252 that is of the gate structure 250 and that is away from the doped layer 240 and the side wall of the doped layer 240, so that the leakage channel between the gate structure 250 and the doped layer 240 is blocked by using the dielectric material.

In some other possible implementations, the side wall 252 that is of the gate structure 250 and that is away from the doped layer 240, the side wall of the dielectric structure 260, and a part of the side wall of the doped layer 240 are flush. FIG. 5 is a schematic diagram of a structure of a semiconductor device according to the invention.

The side wall of the doped layer 240 includes a side wall 241 close to the gate structure 250 and a side wall 242 away from the gate structure 250. The side wall 241 that is of the doped layer 240 and that is close to the gate structure 250, the side wall 252 that is of the gate structure 250 and that is away from the doped layer 240, and the side wall of the dielectric structure 260 are flush, and the side wall 242 that is of the doped layer 240 and that is away from the gate structure 250 and the side wall of the dielectric structure 260 are not flush. Specifically, the side wall 242 that is of the doped layer 240 and that is away from the gate structure 250 may be parallel to the side wall of the dielectric structure 260, or may be not parallel to the side wall of the dielectric structure 260.

In this embodiment of this application, the side wall of the dielectric structure 260 and the side wall 252 that is of the gate structure 250 and that is away from the doped layer 240 are flush. The side wall of the dielectric structure 260 and at least a part of the side wall of the doped layer 240 may not be parallel. Specifically, the side wall of the dielectric structure 260 may not be parallel to the entire side wall of the doped layer 240, or may not be parallel to a part of the side wall of the doped layer 240.

In some possible implementations, the side wall 252 that is of the gate structure 250 and that is away from the doped layer 240 and the side wall of the dielectric structure 260 are flush, and the side wall of the doped layer 240 is not parallel to the side wall of the dielectric structure 260. FIG. 6 is a schematic diagram of a structure of still yet another semiconductor device not falling under the scope of the invention.

An included angle between the side wall of the doped layer 240 and the side wall of the dielectric structure 260 is not equal to 90°, for example, is greater than 90°. Finally, a structure in which the side wall of the gate structure 250 and the side wall of the doped layer 250 are not in a same plane is formed.

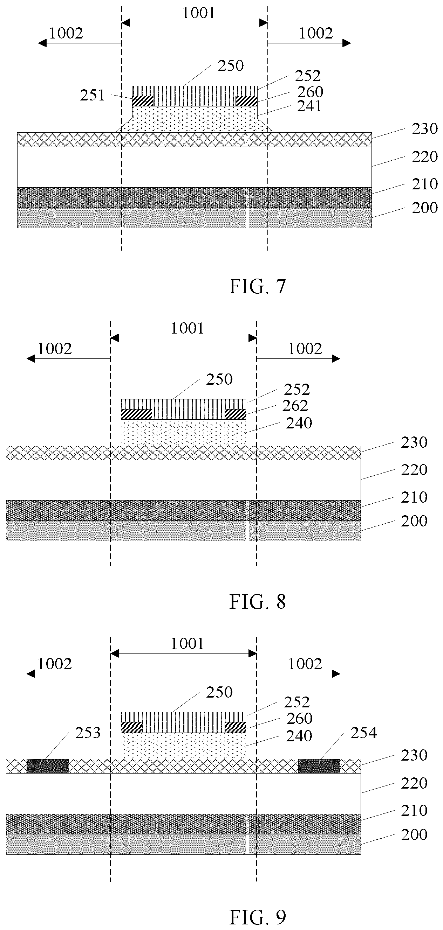

In some other possible implementations, the side wall 252 that is of the gate structure 250 and that is away from the doped layer 240 and the side wall of the dielectric structure 260 are flush, a part of the side wall of the doped layer 240 is not parallel to the side wall of the dielectric structure 260, and the other part of the side wall of the doped layer 240 and the side wall of the dielectric structure 260 may be flush or not flush. FIG. 7 is a schematic diagram of a structure of a further semiconductor device according to the invention.

The side wall of the doped layer 240 includes a side wall 241 close to the gate structure 250 and a side wall 242 away from the gate structure 250. The side wall 241 that is of the doped layer 240 and that is close to the gate structure 250, the side wall 252 that is of the gate structure 250 and that is away from the doped layer 240, and the side wall of the dielectric structure 260 are flush. The side wall 242 that is of the doped layer 240 and that is away from the gate structure 250 is not parallel to the side wall of the dielectric structure 260, and an included angle between the side wall 242 and the side wall of the dielectric structure 260 is not equal to 90°, for example, is greater than 90°.

It can be learned that, for a requirement that the side wall of the gate structure 250 and the side wall of the doped layer 240 not be in a same plane, embodiments of this application provide a plurality of designs of the side wall of the gate structure 250 and the side wall of the doped layer 240, to meet a plurality of requirements in actual application, and there is a relatively large application prospect.

In embodiments of this application, FIG. 4 to FIG. 7 are sectional views, with FIG. 5 and FIG. 7 showing embodiments according to the invention. Therefore, in a plane parallel to a surface of the channel layer 220, the retraction structure may be located on side walls of the gate structure 250, and the dielectric structure 260 may surround the gate structure 250.

In actual application, when the dielectric structure 260 surrounds the gate structure 250, in the plane parallel to the surface of the channel layer 220, widths of a plurality of parts that are of the dielectric structure 260 and that are located on different sides of the gate structure 250 are not completely the same. The width herein refers to a distance between the side wall of the dielectric structure 260 and the side wall 251 that is of the gate structure 250 and that is close to the doped layer 240. FIG. 8 is a schematic diagram of a structure of a still further semiconductor device according to an embodiment not falling under the scope of the invention.

The width of a first part 261, of the dielectric structure 260, located on a left side of the gate structure 250 is greater than the width of a second part 262, of the dielectric structure 260, located on a right side of the gate structure 250. In this way, a design of the gate structure 250 of an asymmetric structure can meet personalized design requirements of some devices, and has a relatively large application prospect.

In embodiments of this application, a size of the dielectric structure in a direction perpendicular to the surface of the channel layer 220 is less than 5 microns (µm), for example, less than 500 nm. That is, a film layer formed by the dielectric material is relatively thin. When the dielectric structure 260 is obtained through etching, damage to a surface of the doped layer 240 is reduced, a leakage current caused by the etching damage is avoided, and device performance is improved.

In this embodiment of this application, FIG. 9 is a schematic diagram of a structure of a yet further semiconductor device according to an embodiment not falling under the scope of the invention.

The semiconductor device may further include a source 253 and a drain 254. The source 253 and the drain 254 are in the non-gate region 1002 and located on a side that is of the barrier layer 230 and that is away from the channel layer 220, and the source 253 and the drain 254 are located on the two sides of the gate region 1001. Both the source 253 and the drain 254 are made of materials with relatively good conductivity, and the materials of the source 253 and the drain 254 are at least one of Ti, TiN, W, Ni, NiV, Ta, TaN, Pd, Pt, WSi₂, and Au.

Embodiments of this application provide the semiconductor device. The semiconductor device may include the channel layer and the barrier layer that are sequentially stacked, the doped layer, and the gate structure. The channel layer and the barrier layer each are made of the group III nitride material. The barrier layer has the gate region. The doped layer is located on the side that is of the barrier layer and that is away from the channel layer. The doped layer is located in the gate region. The material of the doped layer is the group III-V compound including the receptor-type doped element. The gate structure is located on the side that is of the doped layer and that is away from the channel layer. The side wall that is of the gate structure and that is close to the doped layer is retracted relative to the side wall of the doped layer, and the side wall that is of the gate structure and that is close to the doped layer is retracted relative to the side wall that is of the gate structure and that is away from the doped layer, so that the side wall of the gate structure and the side wall of the doped layer are not in the same plane. The retraction structure of the side wall that is of the gate structure and that is close to the doped layer blocks contact between the side wall that is of the gate structure and that is away from the doped layer and the side wall of the doped layer, which is equivalent to blocking the leakage channel between the gate structure and the doped layer, thereby reducing the leakage current of the device and improving the device performance.

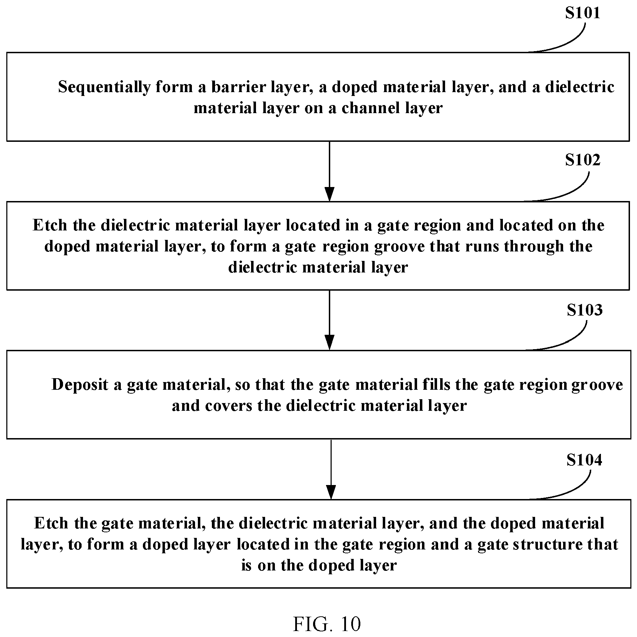

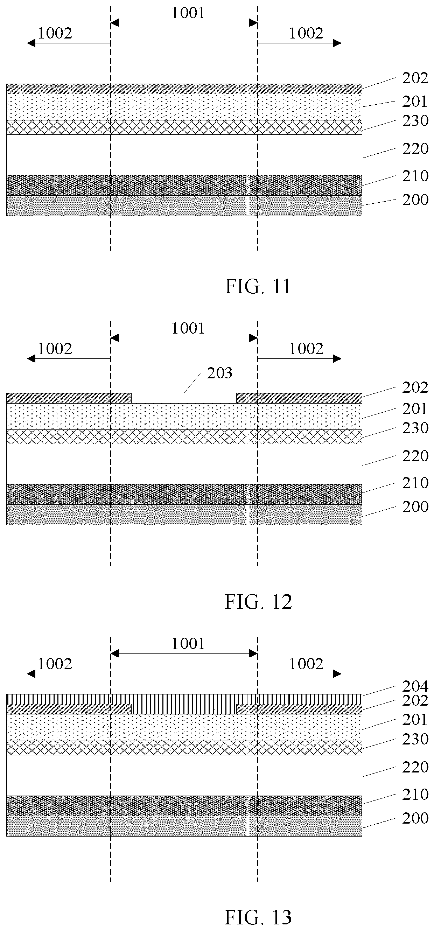

Based on the semiconductor device provided in embodiments of this application, an example useful for understanding the invention further provides a semiconductor device manufacturing method, not falling under the scope of the invention. FIG. 10 is a flowchart of a semiconductor device manufacturing method according to an example. FIG. 11 to FIG. 22 are schematic diagrams of structures of semiconductor devices in a manufacturing process, not falling under the scope of the intervention with only the fully manufactured device structures of FIG. 5 and FIG. 7 forming part of the invention.

The method may include the following steps and is included purely for providing context for the present invention.

S101: Sequentially form a barrier layer 230, a doped material layer 201, and a dielectric material layer 202 on a channel layer 220, as shown in FIG. 11.

In this example, the channel layer 220 is made of a group III nitride material, and the barrier layer 230 is made of a group III nitride material. For example, a material of the channel layer 220 may be gallium nitride, and a material of the barrier layer 230 may be aluminum gallium nitride. In this case, the channel layer 220 and the barrier layer 230 that are disposed in a stacked manner form an AlGaN/GaN heterostructure. In this way, two-dimensional electron gas is generated, and a semiconductor device formed on this basis may work by using the two-dimensional electron gas generated by the heterostructure. The semiconductor device may be, for example, a high-electron-mobility transistor (high-electron-mobility transistor, HEMT) device based on a heterostructure.

In a possible implementation, the thickness of the channel layer 220 may be relatively large. In this case, the channel layer 220 may be used as a substrate, and the substrate supports a film layer that is on the substrate. For example, the channel layer 220 whose material is gallium nitride may be used as the substrate, and is also used as a composition component of the AlGaN/GaN heterostructure.

In another possible implementation, the thickness of the channel layer 220 may be relatively small. Refer to FIG. 11. The channel layer 220 may be formed on the substrate 200, the substrate 200 supports a film layer that is on the substrate, the channel layer 220 is used as a composition component of a heterostructure, and a material of the substrate 200 may be a group III-V compound semiconductor material, and may be one or more of aluminum nitride (AlN), silicon (Si), silicon carbide (SiC), or sapphire. Optionally, a buffer layer 210 may be further disposed between the substrate 200 and the channel layer 220. A material of the buffer layer 210 may be aluminum nitride, or may be gallium nitride growing at a low temperature.

During specific implementation, the buffer layer 210 may be first formed on a surface of the substrate 200, then the channel layer 220 is formed on the buffer layer 210, and then the barrier layer 230, the doped material layer 201, and the dielectric material layer 202 are sequentially formed on the channel layer 220. The channel layer 220, the barrier layer 230, the doped material layer 201, and the dielectric material layer 202 may be formed in a metal organic chemical vapor deposition (Metal organic chemical vapor deposition, MOCVD) manner.

In this example, the barrier layer 230 may have a gate region 1001 and a non-gate region 1002 that is on a periphery of the gate region 1001. The gate region 1001 is a region on a surface of the barrier layer 230, and includes space defined by the surface of the barrier layer 230 and countless straight lines perpendicular to the surface of the barrier layer 230. The gate region 1001 is used to form a gate structure 250. A size of the gate region 1001 may be greater than or equal to that of a region in which the gate structure 250 is located. In FIG. 11, a dashed-line box in the middle represents the gate region 1001, and two sides of the gate region 1001 represent the non-gate region 1002. A same representation manner is used in subsequent schematic diagrams of structures. Because FIG. 11 is a sectional view, the non-gate region 1002 may be actually located on the two sides of the gate region 1001, and may form an annular region, such as a ring region or a polygon region, surrounding the gate region 1001.

In this example, a material of the doped material layer 201 may be a group III-V compound including a receptor-type doped element. For example, the material of the doped material layer 201 may be gallium nitride or aluminum gallium nitride including the receptor-type doped element. In other words, the doped layer may be p-type GaN (p-GaN) or p-type AlGaN (p-AlGaN). A material of the dielectric material layer 202 may be an insulation material, and the material of the dielectric material layer 202 may be at least one of SiO₂, SiON, SiNx, AlOx, AlNx, GaOx, and TiOx.

S102: Etch the dielectric material layer 202 located in the gate region 1001 and located on the doped material layer 201, to form a gate region groove 203 that runs through the dielectric material layer 202, as shown in FIG. 12.

In this example, after the dielectric material layer 202 is formed, the dielectric material layer 202 in the gate region 1001 may be etched, to form the gate region groove 203 that runs through the dielectric material layer 202 and that reaches the doped material layer 201. The gate region groove 203 is located in the gate region 1001, and is configured to form the gate structure 250.

During specific implementation, spin coating of a photoresist may be performed on the dielectric material layer 202, and then processing such as exposure and development is performed on the photoresist to expose the dielectric material layer 202 located in the gate region 1001. Then, the exposed dielectric material layer 202 located in the gate region 1001 is etched to obtain the gate region groove 203 that runs through the dielectric material layer 202. Finally, the photoresist is removed, and the photoresist may be removed through dry etching and wet etching, or may be removed in another manner.

In an actual application, in a direction perpendicular to a surface of the channel layer 220, a size of the dielectric material layer 202 is less than 5 microns (µm), for example, less than 500 nm. That is, a film layer formed by a dielectric material is relatively thin, and it is easy to control etching of the dielectric material layer 202. When the dielectric material layer 202 is etched, damage to a surface of the doped material layer 201 is reduced, a leakage current caused by etching damage is avoided, and device performance is improved. Because the dielectric material layer 202 is relatively thin, the gate region groove 203 may be obtained through dry etching, or the gate region groove 203 may be obtained through wet etching. When the dielectric material layer 202 is etched through wet etching, the dielectric material layer 202 and the doped material layer 201 below the dielectric material layer 202 may each have a relatively high selection ratio, thereby further reducing etching damage to the doped material layer 201.

S103: Deposit a gate material 204, so that the gate material 204 fills the gate region groove 203 and covers the dielectric material layer 202, as shown in FIG. 13.

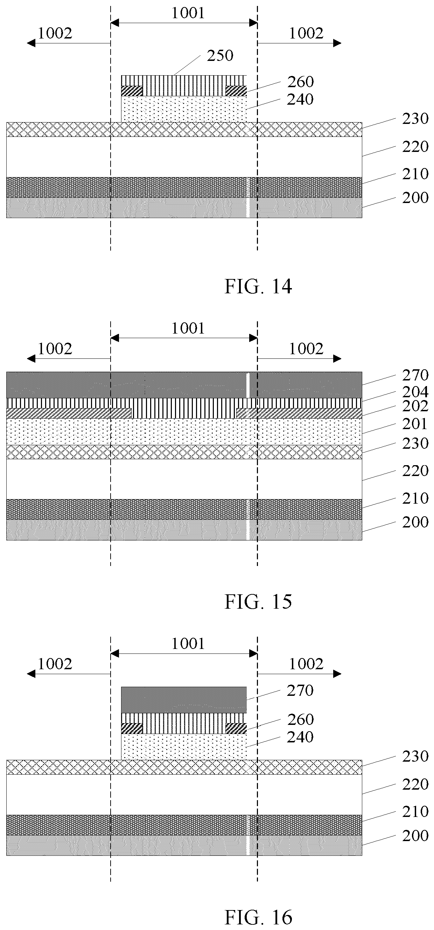

In this example, after the photoresist is removed, the gate material 204 may continue to be deposited, so that the gate material fills the gate region groove 203 and covers the dielectric material layer 202. The gate material may have good conductivity, and a material of the gate material may be at least one of Ti, TiN, W, Ni, NiV, Ta, TaN, Pd, Pt, WSi₂, and Au. A deposition manner of the gate material 204 may be physical vapor deposition (Physical Vapor Deposition, PVD). S104: Etch the gate material 204, the dielectric material layer 202, and the doped material layer 201, to form a doped layer 240 located in the gate region 1001 and the gate structure 250 that is on the doped layer 240, as shown in FIG. 14 to FIG. 22.

In this example, after the gate material 204 is deposited, a gate material 204, a dielectric material layer 202, and a doped material layer 201 that are located outside the gate region 1001 are etched, to finally form the doped layer 240 located in the gate region 1001 and the gate structure 250 on the doped layer 240.

In a plane parallel to the surface of the channel layer 220, the width of the doped layer 240 is greater than the width of the gate region groove 203. To be specific, a dielectric structure 260 is disposed on a periphery of a side wall 251 that is of the finally formed gate structure 250 and that is close to the doped layer 240, so that a side wall 252 that is of the gate structure 250 and that is away from the doped layer 240 and a side wall of the dielectric structure 260 are flush.

During specific implementation, spin coating of a photoresist may be performed on the gate material 204. In the plane parallel to the surface of the channel layer 220, the width of the photoresist is greater than the width of the gate region groove 203, and then processing such as exposure and development is performed on the photoresist, to expose the gate material 204, the dielectric material layer 202, and the doped material layer 201 that are located outside the gate region 1001. Then, dry etching is sequentially performed on the exposed gate material 204, dielectric material layer 202, and doped material layer 201 that are located outside the gate region 1001, and a gate material 204, a dielectric material layer 202, and a doped material layer 201 that are located in the gate region 1001 are reserved. Finally, the photoresist is removed, and the photoresist may be removed through dry etching and wet etching, or may be removed in another manner.

In this example, when the dielectric material layer 202 is etched, an included angle between a side wall of the gate region groove 203 and a bottom surface of the gate region groove 203 is controlled to be equal to 90°, so that the structure shown in FIG. 2 in which an included angle between the side wall 251 that is of the gate structure 250 and that is close to the doped layer 240 and a part of a surface 241 that is of the doped layer 240, that faces the gate structure 250, and that is not covered by the gate structure 250 is equal to 90° may be formed. When the dielectric material layer 202 is etched, an included angle between a side wall of the gate region groove 203 and a bottom surface of the gate region groove 203 is controlled to be not equal to 90°, for example, to be greater than 90°, so that the structure shown in FIG. 3 in which an included angle between the side wall 251 that is of the gate structure 250 and that is close to the doped layer 240 and a part of a surface 241 that is of the doped layer 240, that faces the gate structure 250, and that is not covered by the gate structure 250 is not equal to 90° may be formed, for example, a structure with the included angle less than 90°.

In examples, a manufacturing parameter for etching the gate material 204, the dielectric material layer 202, and the doped material layer 201 may be controlled, to obtain a plurality of stacked structures shown in FIG. 4 to FIG. 7 in which the side wall of the gate structure 250 and the side wall of the doped layer 250 are not in a same plane, to finally form a structure in which the side wall of the dielectric structure 260 and at least a part of the side wall of the doped layer 240 are flush, and/or a structure in which at least a part of the side wall of the doped layer 240 is not parallel to the side wall of the dielectric structure 260.

During specific implementation, after dry etching is sequentially performed, by using the photoresist, on the exposed gate material 204, dielectric material layer 202, and doped material layer 201 that are located outside the gate region 1001, the photoresist may be trimmed, and then dry etching is sequentially performed, by using a trimmed photoresist, on the exposed gate material 204, dielectric material layer 202, and partially doped material layer 201 that are located outside the gate region 1001, to finally obtain the structure shown in FIG. 5 or FIG. 7 in which at least the part of the side wall of the doped layer 240 is parallel to the side wall of the dielectric structure 260.

In an actual application, when the gate material 204, the dielectric material layer 202, and the doped material layer 201 are etched by using the photoresist, the width of the dielectric material layer 202 that is covered by the photoresist and that is located on the left side of the gate region groove 203 may be set to be greater than the width of the dielectric material layer 202 that is covered by the photoresist and that is located on the right side of the gate region groove 203, to obtain the dielectric structure shown in FIG. 8 in which the width of the first part 261 that is of the dielectric structure 260 and that is located on the left side of the gate structure 250 is greater than the width of the second part 262 that is of the dielectric structure 260 and that is located on the right side of the gate structure 250.

In actual application, after the retraction structure on the side wall 251 that is of the gate structure 250 and that is close to the doped layer 240 is formed, the side wall 251 that is of the gate structure 250 and that is close to the doped layer 240 may be further laterally etched, so that the side walls of the gate structure 250 are flush. To be specific, the side wall 251 that is of the gate structure 250 and that is close to the doped layer 240 and the side wall 252 that is of the gate structure 250 and that is away from the doped layer 240 are flush. In this case, a stepped structure is formed between the gate structure 250 and the doped layer 240.

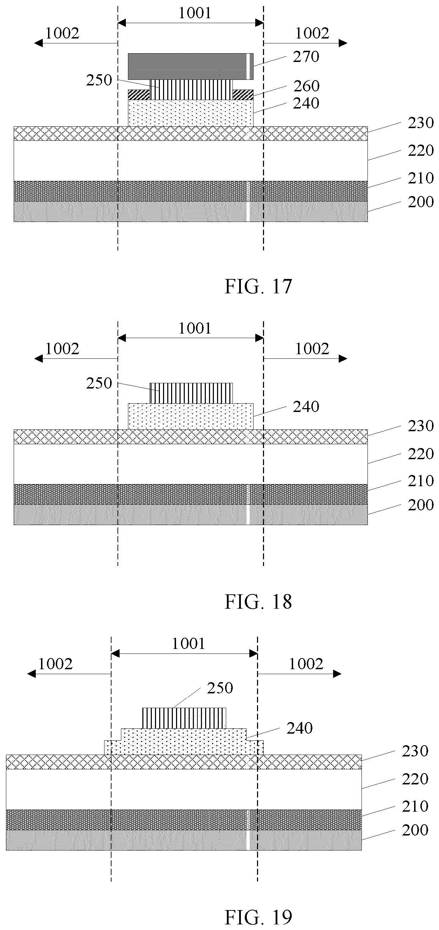

During specific implementation, after the gate material 204 is deposited and before the gate material 204, the dielectric material layer 202, and the doped material layer 201 are etched, a hard mask layer 270 may be formed on the gate material 204. A forming manner of the hard mask layer 270 may be physical vapor deposition (Physical Vapor Deposition, PVD), as shown in FIG. 15. Then, when the gate material 204, the dielectric material layer 202, and the doped material layer 201 are etched, the hard mask layer 270 is also etched, as shown in FIG. 16. After the retraction structure on the side wall 251 that is of the gate structure 250 and that is close to the doped layer 240 is obtained through etching, the gate structure 250 may be laterally etched by using the hard mask layer 270 as a mask and through wet etching, so that at least one side wall of the gate structure 250 is flush, as shown in FIG. 17. When the gate structure 250 is laterally etched through wet etching, there is the dielectric structure 260 around the side wall 251 that is of the gate structure 250 and that is close to the doped layer 240. Therefore, a distance of wet etching can be better controlled, and the wet etching is only for a part that is of the side wall and that is not covered by the dielectric structure 260. Compared with a case in which the entire side wall of the gate structure is laterally etched through wet etching, this manner can improve stability of a manufacturing process and a shape of the side wall of the gate structure 250.

In this example, after the lateral etching of the gate structure 250 is completed, the hard mask layer 270 is removed. Certainly, the hard mask 270 may alternatively not be removed and used as a protective layer of the gate structure 250. The dielectric structure 260 may or may not be removed. The dielectric structure 260 may be removed when the hard mask layer 270 is removed through wet etching, or the hard mask layer 270 and the dielectric structure 260 may be separately removed through two-step manufacturing. A manufacturing sequence of removing the hard mask layer 270 and the dielectric structure 260 is not specifically limited in this application, provided that the stepped structure between the gate structure 250 and the doped layer 240 is finally formed, as shown in FIG. 18.

In this example, the step of performing lateral etching on the gate structure 250 may be performed on the stacked structures formed by the gate structure 250 and the doped layer 240 shown in FIG. 4 to FIG. 8, to obtain the stepped structure between the gate structure 250 and the doped layer 240, as shown in FIG. 19 to FIG. 22.

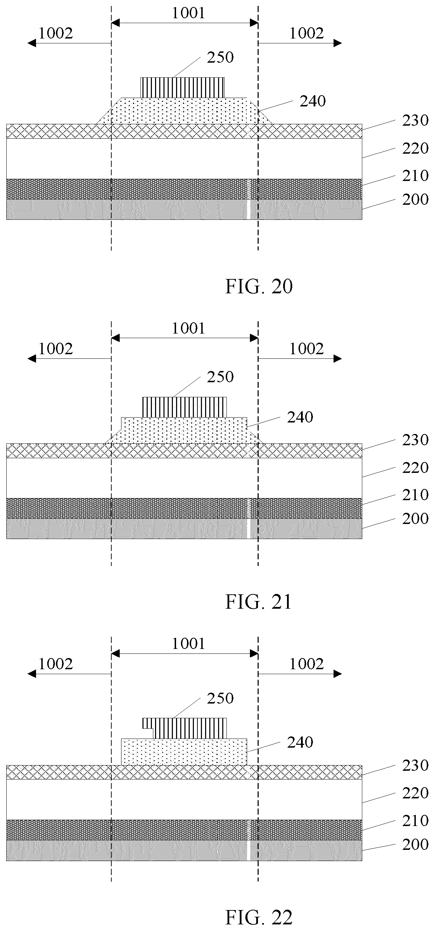

During specific implementation, when the gate structure 250 is laterally etched through wet etching, removed thicknesses of side walls of the gate structure 250 in different directions are the same. For the gate structure 250 of the asymmetric structure shown in FIG. 8, after the lateral etching is completed, at least one side wall of the gate structure 250 may not be flush, as shown in FIG. 22.

It can be learned that the stepped structure that is between the gate structure 250 and the doped layer 240 that is obtained through the foregoing manufacturing post-preparing has a relatively good shape, and the side wall of the gate structure 250 and the surface that is of the doped layer 240 and that is not covered by the gate structure 250 have relatively few etching damages, thereby reducing a leakage current of the device and improving device performance. In this example, refer to FIG. 9. A source 253 and a drain 254 may further be formed in the non-gate region 1002 that is on the barrier layer 230, and the source 253 and the drain 254 are located on the two sides of the gate region 1001. Both the source 253 and the drain 254 are made of materials with relatively good conductivity, and the materials of the source 253 and the drain 254 are at least one of Ti, TiN, W, Ni, NiV, Ta, TaN, Pd, Pt, WSi₂, and Au.

Examples provide the semiconductor device manufacturing method. The barrier layer, the doped material layer, and the dielectric material layer are sequentially formed on the channel layer. The channel layer and the barrier layer each are made of the group III nitride material. The barrier layer has the gate region. The material of the doped material layer is the group III-V compound including the receptor-type doped element. The dielectric material layer located in the gate region and located on the doped material layer is etched, to form the gate region groove that runs through the dielectric material layer. The gate material is deposited, so that the gate material fills the gate region groove and covers the dielectric material layer. The gate material, the dielectric material layer, and the doped material layer are etched, to form the doped layer located in the gate region and the gate structure that is on the doped layer. The dielectric structure is disposed on the periphery of the side wall that is of the gate structure and that is close to the doped layer, so that the side wall that is of the gate structure and that is away from the doped layer and the side wall of the dielectric structure are flush, and the side wall of the gate structure and the side wall of the doped layer are not on a same plane. The dielectric structure of the side wall that is of the gate structure and that is close to the doped layer blocks contact between the side wall that is of the gate structure and that is away from the doped layer and the side wall of the doped layer, which is equivalent to blocking a leakage channel between the gate structure and the doped layer, thereby reducing a leakage current of a device and improving device performance.

Embodiments in this specification are all described in a progressive manner. For same or similar parts in embodiments, refer to each other. Each embodiment focuses on a difference from other embodiments.

## Claims

1. A semiconductor device, comprising:
a channel layer (220) and a barrier layer (230) that are sequentially stacked, wherein the channel layer (220) is made of a group III nitride material, the barrier layer (230) is made of a group III nitride material, and the barrier layer (230) has a gate region (1001);
a doped layer (240), wherein the doped layer (240) is located on a side that is of the barrier layer (230) and that is away from the channel layer (220), the doped layer (240) is located in the gate region (1001), and a material of the doped layer (240) is a group III-V compound comprising a p-type doped element; and
a gate structure (250), wherein the gate structure (250) is located on a side that is of the doped layer (240) and that is away from the channel layer (220); and a side wall (251) that is of the gate structure (250) and that is close to the doped layer (240) is retracted relative to a side wall of the doped layer (240), and the side wall (251) that is of the gate structure (250) and that is close to the doped layer (240) is retracted relative to a side wall (252) that is of the gate structure (250) and that is away from the doped layer (240), so that the side wall of the gate structure (250) that is close to the doped layer and the side wall of the doped layer (240) are not in a same plane wherein a dielectric structure (260) is disposed on a periphery of the side wall (251) that is of the gate structure (250) and that is close to the doped layer (240), so that the side wall (252) that is of the gate structure (250) and that is away from the doped layer (240) and a side wall of the dielectric structure (260) are flush with a part of the side wall of the doped layer (240) that is close to the gate structure (250), **characterized in that** the side wall (252) that is of the gate structure (250) and that is away from the doped layer (240) and the side wall of the dielectric structure (260) are not flush with another part of the side wall that is of the doped layer (240) and that is away from the gate structure (250).

2. The device according to claim 1, wherein a material of the channel layer (220) is gallium nitride, a material of the barrier layer (230) is aluminum gallium nitride, and a material of the doped layer (240) is gallium nitride or aluminum gallium nitride that comprises the p-type doped element.

3. The device according to claim 1 or 2, wherein the other part of the side wall of the doped layer (240) and the side wall of the dielectric structure (260) are not parallel.

4. The device according to claim 1, wherein a material of the dielectric structure (260) comprises at least one of the following materials: SiO₂, SiON, SiNx, AlOx, AlNx, GaOx, or TiOx.

5. The device according to any one of claims 1 to 4, wherein in a plane parallel to a surface of the channel layer (220), the dielectric structure (260) surrounds the gate structure (250), and widths of a plurality of parts that are of the dielectric structure (260) and that are located on different sides of the gate structure (250) are not the same.

6. The device according to any one of claims 1 to 5, wherein a size of the dielectric structure (260) in a direction perpendicular to the surface of the channel layer (220) is less than 5 microns.

7. The device according to any one of claims 1 to 6, wherein a material of the gate structure (250) comprises at least one of the following materials: Ti, TiN, W, Ni, NiV, Ta, TaN, Pd, Pt, WSi₂, and Au.

8. The device according to any one of claims 1 to 7, further comprising:
a source (253) and a drain (254), wherein the source (253) and the drain (254) are located on the side that is of the barrier layer (230) and that is away from the channel layer (220), and the source (253) and the drain (254) are located on two sides of the gate region (1001).

9. The device according to any one of claims 1 to 8, further comprising:
a substrate (200), wherein the substrate (200) is located on a side that is of the channel layer (220) and that is away from the barrier layer (230).

10. The device according to claim 9, further comprising:
a buffer layer (210) located between the substrate (200) and the channel layer (220).

11. An electronic device, comprising a circuit board, and the semiconductor device, connected to the circuit board, according to any one of claims 1 to 10.

## Patentansprüche

1. Halbleitervorrichtung, die Folgendes umfasst:
eine Kanalschicht (220) und eine Barriereschicht (230), die sequenziell gestapelt sind, wobei die Kanalschicht (220) aus einem Gruppe-III-Nitridmaterial besteht, die Barriereschicht (230) aus einem Gruppe-III-Nitridmaterial besteht und die Barriereschicht (230) ein Gate-Gebiet (1001) aufweist;
eine dotierte Schicht (240), wobei sich die dotierte Schicht (240) auf einer Seite befindet, die zu der Barriereschicht (230) gehört und die von der Kanalschicht (220) abgewandt ist, sich die dotierte Schicht (240) in dem Gate-Gebiet (1001) befindet und ein Material der dotierten Schicht (240) eine Gruppe-III-V-Verbindung ist, die ein p-dotiertes Element umfasst; und
eine Gate-Struktur (250), wobei sich die Gate-Struktur (250) auf einer Seite befindet, die zu der dotierten Schicht (240) gehört und die von der Kanalschicht (220) abgewandt ist; und eine Seitenwand (251), die zu der Gate-Struktur (250) gehört und die nahe der dotierten Schicht (240) liegt, relativ zu einer Seitenwand der dotierten Schicht (240) zurückgezogen ist, und die Seitenwand (251), die zu der Gate-Struktur (250) gehört und die nahe der dotierten Schicht (240) liegt, relativ zu einer Seitenwand (252), die zu der Gate-Struktur (250) gehört und die von der dotierten Schicht (240) abgewandt ist, zurückgezogen ist, sodass die Seitenwand der Gate-Struktur (250), die nahe der dotierten Schicht liegt, und die Seitenwand der dotierten Schicht (240) nicht in einer gleichen Ebene liegen, wobei eine dielektrische Struktur (260) auf einer Peripherie der Seitenwand (251), die zu der Gate-Struktur (250) gehört und die nahe der dotierten Schicht (240) liegt, angeordnet ist, sodass die Seitenwand (252), die zu der Gate-Struktur (250) gehört und die von der dotierten Schicht (240) abgewandt ist, und eine Seitenwand der dielektrischen Struktur (260) bündig mit einem Teil der Seitenwand der dotierten Schicht (240), die nahe der Gate-Struktur (250) liegt, sind, **dadurch gekennzeichnet, dass** die Seitenwand (252), die zu der Gate-Struktur (250) gehört und die von der dotierten Schicht (240) abgewandt ist, und die Seitenwand der dielektrischen Struktur (260) nicht bündig mit einem anderen Teil der Seitenwand, die zu der dotierten Schicht (240) gehört und die von der Gate-Struktur (250) abgewandt ist, sind.

2. Vorrichtung nach Anspruch 1, wobei ein Material der Kanalschicht (220) Galliumnitrid ist, ein Material der Barriereschicht (230) Aluminiumgalliumnitrid ist und ein Material der dotierten Schicht (240) Galliumnitrid oder Aluminiumgalliumnitrid ist, das das p-dotierte Element umfasst.

3. Verfahren nach Anspruch 1 oder 2, wobei der andere Teil der Seitenwand der dotierten Schicht (240) und die Seitenwand der dielektrischen Struktur (260) nicht parallel sind.

4. Vorrichtung nach Anspruch 1, wobei ein Material der dielektrischen Struktur (260) mindestens eines der folgenden Materialien umfasst: SiO₂, SiON, SiNx, AlOx, AlNx, GaOx oder TiOx.

5. Vorrichtung nach einem der Ansprüche 1 bis 4, wobei in einer Ebene parallel zu einer Oberfläche der Kanalschicht (220) die dielektrische Struktur (260) die Gate-Struktur (250) umgibt und Breiten mehrerer Teile, die zu der dielektrischen Struktur (260) gehören und die sich auf unterschiedlichen Seiten der Gate-Struktur (250) befinden, nicht gleich sind.

6. Vorrichtung nach einem der Ansprüche 1 bis 5, wobei eine Größe der dielektrischen Struktur (260) in einer Richtung senkrecht zu der Oberfläche der Kanalschicht (220) weniger als 5 Mikrometer beträgt.

7. Vorrichtung nach einem der Ansprüche 1 bis 6, wobei ein Material der Gate-Struktur (250) mindestens eines der folgenden Materialien umfasst: Ti, TiN, W, Ni, NiV, Ta, TaN, Pd, Pt, WSi₂ und Au.

8. Vorrichtung nach einem der Ansprüche 1 bis 7, die ferner Folgendes umfasst:
eine Source (253) und einen Drain (254), wobei sich die Source (253) und der Drain (254) auf der Seite befinden, die zu der Barriereschicht (230) gehört und die von der Kanalschicht (220) abgewandt ist, und sich die Source (253) und der Drain (254) auf zwei Seiten des Gate-Gebiets (1001) befinden.

9. Vorrichtung nach einem der Ansprüche 1 bis 8, die ferner Folgendes umfasst:
ein Substrat (200), wobei sich das Substrat (200) auf einer Seite befindet, die zu der Kanalschicht (220) gehört und die von der Barriereschicht (230) abgewandt ist.

10. Vorrichtung nach Anspruch 9, die ferner Folgendes umfasst:
eine Pufferschicht (210), die sich zwischen dem Substrat (200) und der Kanalschicht (220) befindet.

11. Elektronische Vorrichtung, umfassend eine Leiterplatte und die Halbleitervorrichtung, die mit der Leiterplatte verbunden ist, nach einem der Ansprüche 1 bis 10.

## Revendications

1. Dispositif à semiconducteurs, comprenant :
une couche de canal (220) et une couche de barrière (230) qui sont empilées séquentiellement, dans lequel la couche de canal (220) est réalisée en un matériau de nitrure de groupe III, la couche de barrière (230) est réalisée en un matériau de nitrure de groupe III et la couche de barrière (230) comporte une région de grille (1001) ;
une couche dopée (240), dans lequel la couche dopée (240) est localisée sur un côté qui est de la couche de barrière (230) et qui est à distance de la couche de canal (220), la couche dopée (240) est localisée dans la région de grille (1001) et un matériau de la couche dopée (240) est un composé de groupes III-V comprenant un élément dopé de type p ; et
une structure de grille (250), dans lequel la structure de grille (250) est localisée sur un côté qui est de la couche dopée (240) et qui est à distance de la couche de canal (220) ;
et une paroi latérale (251) qui est de la structure de grille (250) et qui est proche de la couche dopée (240) est en retrait par rapport à une paroi latérale de la couche dopée (240), et la paroi latérale (251) qui est de la structure de grille (250) et qui est proche de la couche dopée (240) est en retrait par rapport à une paroi latérale (252) qui est de la structure de grille (250) et qui est à distance de la couche dopée (240), de telle sorte que la paroi latérale de la structure de grille (250) qui est proche de la couche dopée et la paroi latérale de la couche dopée (240) ne soient pas dans un même plan, dans lequel une structure diélectrique (260) est disposée sur une périphérie de la paroi latérale (251) qui est de la structure de grille (250) et qui est proche de la couche dopée (240), de telle sorte que la paroi latérale (252) qui est de la structure de grille (250) et qui est à distance de la couche dopée (240) et une paroi latérale de la structure diélectrique (260) affleurent une partie de la paroi latérale de la couche dopée (240) qui est proche de la structure de grille (250),
**caractérisé en ce que** la paroi latérale (252) qui est de la structure de grille (250) et qui est à distance de la couche dopée (240) et la paroi latérale de la structure diélectrique (260) n'affleurent pas une autre partie de la paroi latérale qui est de la couche dopée (240) et qui est à distance de la structure de grille (250).

2. Dispositif selon la revendication 1, dans lequel un matériau de la couche de canal (220) est le nitrure de gallium, un matériau de la couche de barrière (230) est le nitrure de gallium et d'aluminium et un matériau de la couche dopée (240) est le nitrure de gallium ou le nitrure de gallium et d'aluminium qui comprend l'élément dopé de type p.

3. Dispositif selon la revendication 1 ou 2, dans lequel l'autre partie de la paroi latérale de la couche dopée (240) et la paroi latérale de la structure diélectrique (260) ne sont pas parallèles.

4. Dispositif selon la revendication 1, dans lequel un matériau de la structure diélectrique (260) comprend au moins l'un des matériaux suivants : SiO₂, SiON, SiNx, AlOx, AlNx, GaOx et TiOx.

5. Dispositif selon l'une quelconque des revendications 1 à 4, dans lequel, dans un plan parallèle à une surface de la couche de canal (220), la structure diélectrique (260) entoure la structure de grille (250), et des largeurs d'une pluralité de parties qui sont de la structure diélectrique (260) et qui sont localisées sur des côtés différents de la structure de grille (250) ne sont pas les mêmes.

6. Dispositif selon l'une quelconque des revendications 1 à 5, dans lequel une dimension de la structure diélectrique (260) dans une direction perpendiculaire à la surface de la couche de canal (220) est inférieure à 5 micromètres.

7. Dispositif selon l'une quelconque des revendications 1 à 6, dans lequel un matériau de la structure de grille (250) comprend au moins l'un des matériaux suivants : Ti, TiN, W, Ni, NiV, Ta, TaN, Pd, Pt, WSi₂ et Au.

8. Dispositif selon l'une quelconque des revendications 1 à 7, comprenant en outre :
une source (253) et un drain (254), dans lequel la source (253) et le drain (254) sont localisés sur le côté qui est de la couche de barrière (230) et qui est à distance de la couche de canal (220), et la source (253) et le drain (254) sont localisés sur deux côtés de la région de grille (1001).

9. Dispositif selon l'une quelconque des revendications 1 à 8, comprenant en outre :
un substrat (200), dans lequel le substrat (200) est localisé sur un côté qui est de la couche de canal (220) et qui est à distance de la couche de barrière (230).

10. Dispositif selon la revendication 9, comprenant en outre :
une couche tampon (210) localisée entre le substrat (200) et la couche de canal (220).

11. Dispositif électronique, comprenant une carte de circuit, et le dispositif à semiconducteurs, connecté à la carte de circuit, selon l'une quelconque des revendications 1 à 10.
